# FASCICULE DE BREVET EUROPEEN

(11) **EP 3 867 957 B1**
(45) Date de publication et mention de la délivrance du brevet: **26.06.2024**
(21) Numéro de dépôt: 19782637.3
(22) Date de dépôt: 10.10.2019
(51) Int. Cl.: H01L 27/15, H05B 45/44

(54) **SOURCE LUMINEUSE MATRICIELLE A ARCHITECTURE AJUSTABLE**
MATRIXLICHTQUELLE MIT EINSTELLBARER ARCHITEKTUR
MATRIX LIGHT SOURCE HAVING AN ADJUSTABLE ARCHITECTURE

(30) Priorité: 15.10.2018 FR 1859542
(43) Date de publication de la demande: 25.08.2021
(73) Titulaire: Valeo Vision, 93012 Bobigny Cedex (FR)
(72) Inventeur: DAROUSSIN, Samuel, 93012 Bobigny Cedex (FR); VAL, Alexandre, 93012 Bobigny Cedex (FR); ZOJCESKI, Zdravko, 93012 Bobigny Cedex (FR)
(74) Mandataire: Valeo Visibility
(86) Numéro de dépôt international: PCT/EP2019/077502
(87) Numéro de publication internationale: WO 2020/078828

(56) Documents cités:
- US-A1- 2017 179 097
- US-A1- 2017 325 300

## Description

L'invention se rapporte aux sources lumineuses matricielles à éléments semi-conducteurs électroluminescents, notamment pour véhicules automobiles. En particulier, l'invention se rapporte à une architecture ajustable de sources lumineuses matricielles.

Une diode électroluminescente, LED, est un composant électronique semi-conducteur capable d'émettre de la lumière lorsqu'il est parcouru par un courant électrique. Dans le domaine automobile, on a de plus en plus recours à la technologie LED pour diverses solutions de signalisation lumineuse. Les LEDs sont utilisées afin d'assurer des fonctions lumineuses telles que les feux diurnes, les feux de signalisation etc... L'intensité lumineuse émise par une LED est en général dépendante de l'intensité du courant électrique qui la traverse. Entre autres, une LED est caractérisée par une valeur seuil d'intensité de courant électrique. Ce courant direct (« forward current ») maximal est en général décroissant à température croissante. De même, lorsqu'une LED émet de la lumière, on observe à ses bornes une chute de tension égale à sa tension directe ou nominale (« forward voltage »).

L'utilité de matrices de LEDs comprenant un nombre important de sources lumineuses électroluminescentes élémentaires est intéressante dans de nombreux domaines d'application, et notamment aussi dans le domaine d'éclairage et de la signalisation des véhicules automobiles. Une matrice de LEDs peut par exemple être utilisée pour créer des formes de faisceaux lumineux intéressantes pour des fonctions lumineuses telles que les feux/l'éclairage de route ou les éclairages diurnes. En plus, plusieurs fonctions lumineuses différentes peuvent être réalisées à l'aide d'une matrice unique, réduisant ainsi l'encombrement physique dans l'espace restreint d'un éclairage de véhicule automobile.

De manière connue, des sources lumineuses matricielles ou, de manière équivalente, pixelisées, sont commandées par une unité de commande physiquement déportée et électriquement connectée à la source lumineuse. Il a été proposé d'intégrer au moins une partie des circuits électroniques nécessaires au pilotage d'une source lumineuse dans un circuit intégré de type ASIC (« application spécifie integrated circuit ») sur lequel une matrice de sources lumineuses est posée. Cependant, dépendant de la taille de la matrice de sources lumineuses, les circuits intégrés connus doivent être redéveloppés pour chaque application. Par ailleurs, le rendement de production de matrices de sources lumineuses élémentaires à éléments semi-conducteurs ayant des caractéristiques homogènes reste limité. Il est notamment difficile de maîtriser la production de matrices d'envergure importante, qui permettraient pourtant la réalisation d'applications plus diverses. Le document US2017/325300 A1 divulgue une source lumineuse matricielle comprenant un circuit intégré et des interrupteurs montés en parallèle de diodes électroluminescentes. Le document US2017/179097 divulgue un écran couleur LED et la méthode pour le fabriquer par collage en alignement et retrait de substrat.

L'invention a pour objectif de pallier à au moins un des problèmes posés par l'art antérieur.

Un premier aspect de l'invention concerne une source lumineuse matricielle selon la revendication 1.

De préférence, la distance entre les composants matriciels peut être inférieure à 10 µm.

Le substrat de la zone de réception peut de préférence comprendre au moins une partie du circuit électronique.

De préférence, les sources lumineuses élémentaires peuvent être électriquement connectées au circuit électronique par des connexions verticales par rapport à l'étendue de la zone de réception.

De préférence, la matrice de sources lumineuses élémentaires peut se composer d'au moins deux composants matriciels distincts.

La source lumineuse matricielle peut de préférence s'étendre le long d'un axe principal.

De préférence, la zone de connexion peut s'étendre le long d'au moins un bord du circuit intégré qui suit l'axe principal. Ledit bord peut de préférence être parallèle à l'axe principal.

La zone de connexion peut de préférence comprendre des moyens de connexion à une source d'électricité, 1es moyens de connexion étant formés par une couche de métal. Il s'agit de préférence de métal a forte conduction électrique, par exemple du cuivre Cu, de l'aluminium, Al, de l'or, Au ou de l'argent Ag.

De préférence, la zone de connexion peut comprendre une pluralité de plots de connexion, dont les étendues respectives dépendent des signaux et/ou des intensités de courant électrique qu'elles sont destinées à transmettre. Les moyens de connexion peuvent de préférence comprendre lesdits plots de connexion.

La zone de connexion peut de préférence comprendre un plot de connexion, possiblement distribué sur plusieurs parties interconnectées de la zone de connexion, dont l'étendue est apte à transmettre un courant d'une intensité d'au moins 15A.

De préférence, la source lumineuse peut être composée de composants matriciels de dimensions similaires et comprenant un nombre de sources lumineuse élémentaires identique.

La source lumineuse peut de préférence comprendre au moins un composant matriciel de dimensions 7x11 sources lumineuse élémentaires, 14x11, 28x22 ou 44x28. La source lumineuse peut de préférence comprendre une combinaison de ces composants matriciels.

Selon un autre aspect de l'invention, un module lumineux pour un véhicule automobile selon la revendication 8 est proposé.

De préférence, le substrat du circuit intégré peut être en contact thermique avec l'élément de dissipation thermique. La source lumineuse matricielle peut de préférence être électriquement reliée au circuit imprimé moyennant au moins une connexion par pontage.

Le circuit intégré peut de préférence comprendre un substrat en Si. De préférence, le circuit intégré est soudé ou collé à la matrice de sources lumineuses élémentaires, par exemple à un au substrat commun supportant les sources lumineuses élémentaires. De préférence, le circuit intégré est en contact mécanique, par exemple par le biais de moyens de fixation, et électrique avec une couche inférieure des sources lumineuses élémentaires.

La source lumineuse pixélisée, ou de manière équivalente, la source lumineuse matricielle, ou encore un des composant matriciels de la source lumineuse matricielle, peut de préférence comprendre au moins une matrice d'éléments électroluminescents - les sources lumineuse élémentaires - (appelée en anglais monolithic array) agencés selon au moins deux colonnes par au moins deux lignes. De préférence, la source électroluminescente comprend au moins une matrice d'éléments électroluminescents monolithique, aussi appelée matrice monolithique.

Dans une matrice monolithique, les éléments électroluminescents sont crûs depuis un substrat commun et sont connectés électriquement de manière à être activables sélectivement, individuellement ou par sous-ensemble d'éléments électroluminescents. Ainsi chaque élément électroluminescent ou groupe d'éléments électroluminescents peut former l'un des émetteurs élémentaires de ladite source lumineuse pixélisée qui peut émettre de la lumière lorsque son ou leur matériau est alimenté en électricité

Différents agencements d'éléments électroluminescents peuvent répondre à cette définition de matrice monolithique, dès lors que les éléments électroluminescents présentent l'une de leurs dimensions principales d'allongement sensiblement perpendiculaire à un substrat commun et que l'écartement entre les émetteurs élémentaires, formés par un ou plusieurs éléments électroluminescents regroupés ensemble électriquement, est faible en comparaison des écartements imposés dans des agencements connus de chips carrés plates soudés sur une carte de circuits imprimés.

Le substrat du composant monolithique peut être maj oritairement en matériau semi-conducteur. Le substrat peut comporter un ou plusieurs autres matériaux, par exemple non semi-conducteurs. Ces éléments électroluminescents, de dimensions submillimétriques, sont par exemple agencés en saillie du substrat de manière à former des bâtonnets de section hexagonale. Les bâtonnets électroluminescents prennent naissance sur une première face d'un substrat. Chaque bâtonnet électroluminescent, ici formé par utilisation de nitrure de gallium (GaN), s'étend perpendiculairement, ou sensiblement perpendiculairement, en saillie du substrat, ici réalisé à base de silicium, d'autres matériaux comme du carbure de silicium pouvant être utilisés sans sortir du contexte de l'invention. A titre d'exemple, les bâtonnets électroluminescents pourraient être réalisés à partir d'un alliage de nitrure d'aluminium et de nitrure de gallium (AlGaN), ou à partir d'un phosphure d'aluminium, d'indium et de gallium (AlInGaP). Chaque bâtonnet électroluminescent s'étend selon un axe d'allongement définissant sa hauteur, la base de chaque bâtonnet étant disposée dans un plan de la face supérieure du substrat.

Les bâtonnets électroluminescents d'une même matrice monolithique présentent avantageusement la même forme et les mêmes dimensions. Ils sont chacun délimités par une face terminale et par une paroi circonférentielle qui s'étend le long de l'axe d'allongement du bâtonnet. Lorsque les bâtonnets électroluminescents sont dopés et font l'objet d'une polarisation, la lumière résultante en sortie de la source à semi-conducteurs est émise essentiellement à partir de la paroi circonférentielle, étant entendu que des rayons lumineux peuvent sortir également de la face terminale. Il en résulte que chaque bâtonnet électroluminescent agit comme une unique diode électroluminescente et que la luminance de cette source est améliorée d'une part par la densité des bâtonnets électroluminescents présents et d'autre part par la taille de la surface éclairante définie par la paroi circonférentielle et qui s'étend donc sur tout le pourtour, et toute la hauteur, du bâtonnet. La hauteur d'un bâtonnet peut être comprise entre 2 et 10 µm, préférentiellement 8 µm. La plus grande dimension de la face terminale d'un bâtonnet est inférieure à 2 µm, préférentiellement inférieure ou égale à 1 µm.

On comprend que, lors de la formation des bâtonnets électroluminescents, la hauteur peut être modifiée d'une zone de la source lumineuse pixélisée à l'autre, de manière à accroitre la luminance de la zone correspondante lorsque la hauteur moyenne des bâtonnets la constituant est augmentée. Ainsi, un groupe de bâtonnets électroluminescents peut avoir une hauteur, ou des hauteurs, différentes d'un autre groupe de bâtonnets électroluminescents, ces deux groupes étant constitutifs de la même source lumineuse à semi-conducteur comprenant des bâtonnets électroluminescents de dimensions submillimétriques. La forme des bâtonnets électroluminescents peut également varier d'une matrice monolithique à l'autre, notamment sur la section des bâtonnets et sur la forme de la face terminale. Les bâtonnets présentent une forme générale cylindrique, et ils peuvent notamment présenter une forme de section polygonale, et plus particulièrement hexagonale. On comprend qu'il importe que de la lumière puisse être émise à travers la paroi circonférentielle, que celle-ci présente une forme polygonale ou circulaire.

Par ailleurs, la face terminale peut présenter une forme sensiblement plane et perpendiculaire à la paroi circonférentielle, de sorte qu'elle s'étend sensiblement parallèlement à la face supérieure du substrat, ou bien elle peut présenter une forme bombée ou en pointe en son centre, de manière à multiplier les directions d'émission de la lumière sortant de cette face terminale.

Les bâtonnets électroluminescents peuvent de préférence être agencés en matrice à deux dimensions. Cet agencement pourrait être tel que les bâtonnets soient agencés en quinconce. De manière générale, les bâtonnets sont disposés à intervalles réguliers sur le substrat et la distance de séparation de deux bâtonnets électroluminescents immédiatement adjacents, dans chacune des dimensions de la matrice, doit être au minimum égale à 2 µm, préférentiellement comprise entre 3 µm et 10 µm, afin que la lumière émise par la paroi circonférentielle de chaque bâtonnet puisse sortir de la matrice de bâtonnets électroluminescents. Par ailleurs, on prévoit que ces distances de séparation, mesurées entre deux axes d'allongement de bâtonnets adjacents, ne soient pas supérieures à 100 µm.

Alternativement, la matrice monolithique peut comporter des éléments électroluminescents formés par des couches d'éléments électroluminescents épitaxiées, notamment une première couche en GaN dopée n et une seconde couche en GaN dopée p, sur un substrat unique, par exemple en saphir ou en carbure de silicium, et que l'on découpe (par meulage et/ou ablation) pour former une pluralité d'émetteurs élémentaires respectivement issus d'un même substrat. Il résulte d'une telle conception une pluralité de blocs électroluminescents tous issus d'un même substrat et connectés électriquement pour être activables sélectivement les uns des autres.

Dans un exemple de réalisation selon cet autre mode, le substrat de la matrice monolithique peut présenter une épaisseur comprise entre 5 µm et 800 µm, notamment égale à 200 µm ; chaque bloc peut présenter une longueur et une largeur, chacune étant comprise entre 50 µm et 500 µm, préférentiellement comprise entre 100 µm et 200 µm. Dans une variante, la longueur et la largeur sont égales. La hauteur de chaque bloc est inférieure à 500 µm, préférentiellement inférieur à 300 µm. Enfin la surface de sortie de chaque bloc peut être faite via le substrat du côté opposé à l'épitaxie. La distance de séparation entre deux émetteurs élémentaires. La distance entre chaque émetteur élémentaire contigu peut être inférieure à 1 mm, notamment inférieure à 500 µm, et elle est préférentiellement inférieure à 200 µm.

Alternativement, aussi bien avec des bâtonnets électroluminescents s'étendant respectivement en saillie d'un même substrat, tels que décrit ci-dessus, qu'avec des blocs électroluminescents obtenus par découpage de couches électroluminescentes superposées sur un même substrat, la matrice monolithique peut comporter en outre une couche d'un matériau polymère dans laquelle les éléments électroluminescents sont au moins partiellement noyés. La couche peut ainsi s'étendre sur toute l'étendue du substrat ou seulement autour d'un groupe déterminé d'éléments électroluminescents. Le matériau polymère, qui peut notamment être à base de silicone, crée une couche protectrice qui permet de protéger les éléments électroluminescents sans gêner la diffusion des rayons lumineux. En outre, il est possible d'intégrer dans cette couche de matériau polymère des moyens de conversion de longueur d'onde, et par exemple des luminophores, aptes à absorber au moins une partie des rayons émis par l'un des éléments et à convertir au moins une partie de ladite lumière d'excitation absorbée en une lumière d'émission ayant une longueur d'onde différente de celle de la lumière d'excitation. On pourra prévoir indifféremment que les luminophores sont noyés dans la masse du matériau polymère, ou bien qu'ils soient disposés en surface de la couche de ce matériau polymère.

La source lumineuse pixélisée peut comporter en outre un revêtement de matériau réfléchissant pour dévier les rayons lumineux vers les surfaces de sorties de la source lumineuse.

Les éléments électroluminescents de dimensions submillimétriques définissent dans un plan, sensiblement parallèle au substrat, une surface de sortie déterminée. On comprend que la forme de cette surface de sortie est définie en fonction du nombre et de l'agencement des éléments électroluminescents qui la composent. On peut ainsi définir une forme sensiblement rectangulaire de la surface d'émission, étant entendu que celle-ci peut varier et prendre n'importe quelle forme sans sortir du contexte de l'invention.

En utilisant les mesures proposées par la présente invention, il devient possible de proposer une architecture ajustable de sources lumineuses matricielles. D'une part, selon des modes de réalisations de l'invention, une architecture modulaire du circuit intégré qui abrite un ou plusieurs composants matriciels à sources lumineuses électroluminescentes élémentaires permet la réalisation à plusieurs tailles, en répétant la structure d'un module de circuit intégré intégralement le long d'un axe principal de la source matricielle. D'autre part, la source lumineuse matricielle selon des aspects de l'invention permet d'accorder la taille du circuit intégré à la taille du/des composants matriciels disponibles. Comme la source lumineuse matricielle permet d'y implanter une pluralité de composants matriciels, une source lumineuse matricielle de large étendue peut être réalisée en utilisant deux ou plusieurs composants matriciels de taille réduite, dont les caractéristiques lumineuses sont similaires et dont la production homogène est mieux maîtrisée que celle de composants matriciels plus grands. L'homogénéité optique de la source matricielle s'en voit par conséquent améliorée. En plus, comme tous les composants matriciels se partagent le même substrat, qui est de préférence fixé directement sur un élément de dissipation thermique, la dissipation thermique au niveau de l'intégralité de la source matricielle est homogénéisée.

D'autres caractéristiques et avantages de la présente invention seront mieux compris à l'aide de la description des exemples et des dessins parmi lesquels :
- la figure 1 montre de manière schématique une vue d'en haut d'une source lumineuse matricielle selon un mode de réalisation préféré de l'invention ;
- la figure 2 montre de manière schématique une coupe transversale d'une source lumineuse matricielle selon un mode de réalisation préféré de l'invention ;
- la figure 3 montre de manière schématique une vue d'en haut d'un circuit intégré d'une source lumineuse matricielle selon un mode de réalisation préféré de l'invention.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre d'exemples et de manière non limitative. Des numéros de référence similaires seront utilisés pour décrire des concepts semblables à travers différents modes de réalisation de l'invention. Par exemple, les références 100 et 200 désignent deux modes de réalisation d'une source lumineuse matricielle selon l'invention.

La description se concentre sur les éléments et composants d'un véhicule automobile qui sont directement en relation avec les aspects de l'invention. D'autres éléments bien connus ne seront pas décrits en détails ou mentionnés. Pour l'exemple d'un module lumineux en accord avec des aspects de l'invention, il s'agit par exemple et de manière non limitative d'éléments optiques tels que des lentilles optiques ou des réflecteurs, ou de supports divers pour maintenir des composants à leurs emplacements prévus.

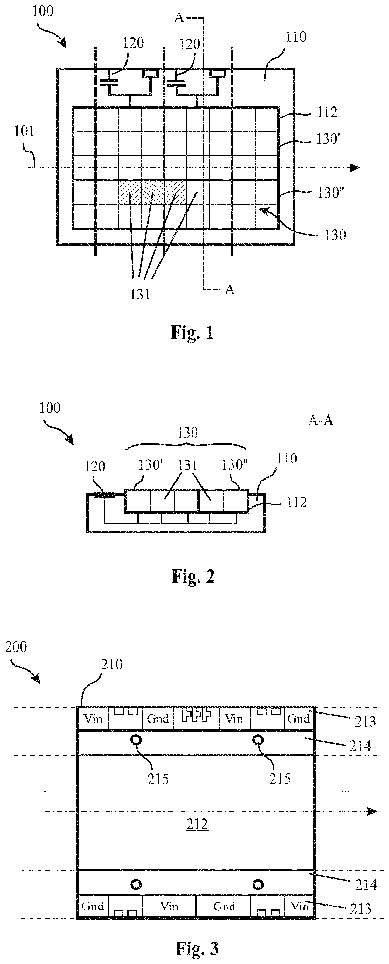

L'illustration de la figure 1 montre une source lumineuse pixelisée ou matricielle 100 selon un mode de réalisation préféré de l'invention. La source lumineuse 100 comprend un circuit intégré 110 ainsi qu'une matrice 130 qui comprend une pluralité de sources lumineuses élémentaires à élément électroluminescent 131. Le circuit intégré est de préférence produit moyennant la technologie bien connue CMOS (« complementary métal oxyde semiconductor ») et il comprend notamment au moins un circuit électronique 120 destiné au pilotage de l'alimentation électrique des sources lumineuses élémentaires 131. De manière non-limitative, le circuit électronique 120 peut par exemple comprendre des moyens de connexion à une source d'électricité externe à la source matricielle, telle qu'une batterie ou un convertisseur apte à fournir un courant électrique d'une intensité adaptée à l'alimentation des sources lumineuses élémentaires. Le circuit électronique peut en outre comprendre des éléments interrupteurs, réalisés par exemple moyennant des transistors à effet de champ de type MOSFET, qui permettent d'alimenter de manière sélective les sources élémentaires 131 de manière individuelle ou par groupes, conformément à des commandes reçues. A cet effet, le circuit électronique peut comprendre un circuit de réception d'une telle commande, la commande étant générée par une entité externe à la source matricielle.

Le circuit intégré 110 comprend une zone de réception 112 destinée à abriter la matrice 130. La zone de réception est de préférence de forme rectangulaire. La géométrie du circuit intégré 110 est particulière en ce qu'au moins une partie de sa structure, y compris la zone de réception et le circuit électronique qui y est intégré, se répète au moins une fois le long d'une axe principal 101.

Sur l'illustration de la figure 1, la partie du circuit intégré qui est répétée se situe entre deux lignes verticales a traits interrompus. Chaque répétition de cette structure est réalisée en utilisant un masque identique lors de la production du circuit intégré par la technologie CMOS. Evidemment, l'invention ne se limite pas à une répétition unique de la structure. Selon la taille de la matrice 130 qui sera abritée par le circuit intégré, le même masque peut être utilisé le long de l'axe principal 101 pour étendre le circuit intégré, afin d'augmenter le nombre de pixels adressables de la matrice 130. Comme le circuit électronique 120 de chaque partie répétée comprend les composants électroniques nécessaires à l'alimentation et à la commande des sources lumineuse élémentaires 131 qui sont abritées par la partie répétée correspondante de la zone de réception 112, l'architecture est ajustable en taille le long de l'axe 101.

Dans l'exemple montré, deux composants matriciels 130' et 130" sont utilisés pour réaliser la matrice 130. Les composants matriciels sont par exemple produits de manière indépendante l'un de l'autre.

La figure 2 montre une coupe transversale selon l'axe A-A indiqué sur la figure 1. On y aperçoit la zone de réception 112 qui est de préférence réalisée par un évidement rectangulaire du substrat, généralement en silicone, Si, du circuit intégré. Cette caractéristique géométrique n'est pourtant pas limitative de l'invention. Le circuit électronique 120 comprend des connexions au niveau de la zone de réception 112, qui permettent notamment de contacter électriquement chacune des sources lumineuses élémentaires 131 de manière individuelle par leur face inférieure qui est en contact avec le substrat de la zone de réception 112. La connexion verticale ainsi réalisée par des éléments noyés dans le circuit intégré permet de s'affranchir de câblages individuels pour les sources lumineuses élémentaires.

La source lumineuse matricielle 100 comprend une matrice 130 de sources lumineuses élémentaires à élément semi-conducteur électroluminescent 131 et peut comprendre un substrat commun non-illustré, en contact mécanique et électrique avec et fonctionnellement relié au circuit intégré 120. Les sources lumineuses élémentaires sont typiquement des diodes électroluminescentes, LED.

La source lumineuse matricielle 100 comprend de préférence, mais de manière non-limitative, un composant matriciel monolithique, dans lequel les couches semi-conductrices des sources lumineuses élémentaires 131 sont, par exemple, disposées sur le substrat commun. La matrice de sources lumineuses élémentaires 130 comprend de préférence un montage en parallèle d'une pluralité de branches, chaque branche comprenant des sources lumineuses semi-conductrices électroluminescentes 131.

La matrice de sources lumineuses élémentaires 130 comprend à titre d'exemple et non-limitatif, selon l'épaisseur du substrat et commençant par l'extrémité opposée à l'emplacement des sources élémentaires 310, une première couche électriquement conductrice déposée sur un substrat électriquement isolant. Il suit une couche semi-conductrice dopée n, dont l'épaisseur se situe entre 0.1 et 2 µm. a couche suivante est la couche active de puits quantiques d'une épaisseur d'environ 30 nm, suivie d'une couche bloquant des électrons, et finalement une couche semi-conductrice dopée p, cette dernière ayant une épaisseur d'environ 300nm. De préférence, la première couche est une couche de (Al)GaN:Si, la deuxième couche une couche de n-GaN:Si, la couche active comprend des puits quantiques en InGaN alternant avec des barrières en GaN. La couche bloquante est de préférence en AlGaN:Mg et la couche dopée p est de préférence en p-GaN:Mg.

Afin d'obtenir des sources lumineuses élémentaires 131 présentant des couches semi-conductrices ayant des épaisseurs homogènes, le composant monolithique est de préférence fabriqué en déposant les couches de manière homogène et uniforme sur au moins une partie de la surface du substrat, de manière à la recouvrir. Le dépôt des couches est par exemple réalisé par un procédé d'épitaxie en phase vapeur aux organométalliques (« métal oxide chemical vapor déposition »), MOCVD. De tels procédés ainsi que des réacteurs pour leur mise en oeuvre sont connus pour déposer des couches semi-conductrices sur un substrat, par exemple depuis les documents de brevet WO 2010/072380 A1 ou WO 01/46498 A1. Les détails de leur mise en oeuvre ne seront par conséquent pas détaillés dans le cadre la présente invention. Ensuite, les couches ainsi formées sont pixélisées. A titre d'exemple et non-limitatif, les couches sont enlevées par des procédés lithographiques connus et par etching aux endroits qui correspondent par la suite aux espaces séparant les sources lumineuses élémentaires 131 les unes des autres sur le substrat. Ainsi, une pluralité de plusieurs dizaines ou centaines ou milliers de pixels 131 de surface inférieure à un millimètre-carré pour chaque pixel individuel, et de surface totale supérieure à 2 millimètre-carré ayant des couches semi-conductrices à épaisseurs homogènes, et présentant donc des résistances série internes homogènes et élevées peuvent être produites sur le substrat d'une source lumineuse matricielle. De manière générale, plus la taille de chaque pixel de LED diminue, plus sa résistance série augmente, et plus ce pixel est adapté à être piloté par une source de tension. Alternativement, le substrat comprenant les couches épitaxiées recouvrant au moins une partie de la surface du substrat est scié ou coupé en sources lumineuses élémentaires, chacune des sources lumineuses élémentaires ayant des caractéristiques similaires au niveau de leur résistance série interne.

L'invention se rapporte à même titre à des types de sources lumineuses élémentaires à éléments semi-conducteurs impliquant d'autres configurations de couches semi-conductrices. Notamment les substrats, les matériaux semi-conducteurs des couches, l'agencement des couches, leurs épaisseurs et d'éventuels vias entre les couches peuvent être différents de l'exemple qui vient d'être décrit.

Le circuit intégré 110 est de préférence soudé sur la face inférieure de la matrice, qui abrite les sources lumineuses élémentaires sur sa face supérieure, de manière à établir un contact mécanique et électrique avec le substrat et les sources lumineuses élémentaires. L'utilisation d'un circuit intégré 110 en contact mécanique et électrique avec le substrat sur lequel résident les sources lumineuses élémentaires, permet de s'affranchir de connexions filaires, dont le nombre serait au moins égal au nombre de pixels de la source lumineuse matricielle. De préférence, un circuit d'alimentation peut être intégré dans le substrat lors de la fabrication du composant monolithique.

L'illustration de la figure 3 montre une source lumineuse pixelisée ou matricielle 200 selon un autre mode de réalisation préféré de l'invention. La source lumineuse 200 comprend un circuit intégré 210 ainsi qu'une matrice non-illustrée, qui se compose d'une pluralité de sources lumineuses élémentaires à élément électroluminescent. Le circuit intégré est de préférence produit moyennant la technologie bien connue CMOS (« complementary métal oxyde semiconductor ») et il comprend notamment au moins un circuit électronique destiné au pilotage de l'alimentation électrique des sources lumineuses élémentaires. Au moins une zone de connexion 213, 214 du circuit intégré permet de relier le circuit électronique à d'autre composants externes. La zone de connexion 213, 214 s'étend le long d'un bord qui suit l'axe principal du circuit intégré. Dans l'exemple de la figure 2, des zones de connexion 213, 214 ont prévues sur les deux bords opposés qui suivent l'axe principal.

La partie 213 de la zone de connexion permet notamment de connecter la source lumineuse matricielle 200 à une source d'électricité externe. De préférence, le substrat en Si du circuit intégré est directement soudé ou collé moyennant une colle thermique à un élément de dissipation thermique, par exemple constitué d'un bloc en aluminium. La zone de connexion 213 permet de connecter les circuits électroniques implantés dans le circuit intégré 210 à différents potentiels électriques Vin, Gnd, ainsi que de préférence des signaux logiques de commandes numériques par liaison de pontage directe à un circuit imprimé externe qui abrite les sources électriques correspondantes. A cet effet, la zone de connexion comprend des plots de connexions dédiés. Les plots Vin, Gnd peuvent par exemple avoir une étendue maximale qui permet la transmission d'une courant électrique d'une forte intensité, par exemple d'au moins 15 A. D'autres plots de connexion, prévus pour la transmission de commandes numériques, peuvent avoir des étendues plus restreintes. Les liaisons de pontage peuvent par conséquent également être réalisées moyennant des fils ou rubans de dimensions adaptées. Pour la transmission de signaux numérique, des fils de 50 u 125 µm de diamètre peuvent être utilisées. Par exemple, des rubans de 400×100µm ou un fil de 200µm de diamètre peut être utilisé pour la transmission d'un courant électrique intense. De préférence, la zone de connexion peut comprendre quatre connexion aptes à transmettre un courant électrique de forte intensité, distribuées sur deux bords du circuit intégré.

La liaison thermique directe entre le substrat en Si d'un circuit intégré et un élément de dissipation thermique, ainsi que la liaison de pontage directe à un circuit externe peut également s'appliquer à d'autres types de circuits intégrés, qui ne comprennent pas les autres caractéristiques conformes aux aspects de la présente invention.

Une connexion par pontage selon la technique connue sous le nom de « wire bonding » ou « ribbon bonding » ou encore « copper clip » en anglais est utilisée à cet effet. Ce type de connexion permet la transmission de courant électriques élevées et la transmission rapide de signaux logiques. La connexion comprend un plot de connexion sur le circuit imprimé et dans la zone de connexion 213 du circuit intégré 210, et un fil électriquement conducteur qui relie les deux plots de connexion. Chaque plot de connexion est électriquement relié au circuit électronique du circuit imprimé/circuit intégré respectif. Le fil électriquement conducteur est soudé entre les deux plots de connexion, par exemple par soudage ultrason. Le matériau du fil est de l'aluminium, de l'or, du cuivre, ou de l'argent tandis que son diamètre est compris entre 75µm et 250µm. Selon un mode de réalisation préféré, les plots de connexions comprennent au moins sur leur surface une couche du même matériau duquel le fil est constitué, afin de faciliter l'étape de soudage.

Les zones de connexions 213, 214 comprennent de préférence une couche de métal dont les dimensions sont adaptées à conduire des courant électriques de forte intensité, par exemple de plus de 15 A. En effet, la source matricielle doit être apte à gérer des courants électriques intenses vu le nombre important de sources lumineuse élémentaire qu'elle peut abriter.

Le circuit intégré 210 comprend en outre une zone de réception 212 adjacente à la zone de connexion 213,214 et destinée à abriter la matrice de sources lumineuses élémentaires. La zone de réception est de préférence de forme rectangulaire. La géométrie du circuit intégré 210 est particulière en ce que au moins une partie de sa structure, y compris la zone de réception et le circuit électronique qui y est intégré, se répète au moins une fois le long d'un axe principal. Sur l'illustration de la figure 3, seule une la partie du circuit intégré qui est répétée est montrée, les répétitions ne sont pas illustrées. Cette structure est réalisée en utilisant un masque identique lors de la production du circuit intégré par la technologie CMOS. Les répétitions sont avantageusement réalisées sans décalage entre les structures répétées mais des variantes peuvent être réalisées avec un décalage, dans la mesure où la fonction matricielle n'est pas altérée. Comme la taille du circuit intégré 210 peut devenir importante dépendant du nombre de répétitions du motif modulaire du circuit intégré le long de l'axe principal, des ouvertures traversantes, ou trous 215 sont prévus au niveau de la zone de connexion 213, 214 du circuit intégré 210, afin d'y réduire les tensions mécaniques. Cette mesure réduit notamment le risque de décollage des plots de connexion utilisés dans les liaisons par pontage dû à des tensions mécaniques dans le substrat du circuit intégré 210.

Il va de soi que le circuit intégré peut comprendre d'autres circuits électroniques et/ou éléments de mémoire utilisés pour d'autres fonctions en rapport avec la source lumineuse matricielle et/ou avec les sources lumineuses élémentaires. Ceci comprend mais ne se limite pas à des circuits de détection d'un court-circuit, ou d'un défaut en circuit-ouvert d'une source lumineuse élémentaire.

L'étendue de la protection est déterminée par les revendications.

## Revendications

1. Source lumineuse matricielle (100, 200) comprenant un circuit intégré (110, 210) et une matrice (130) de sources lumineuses élémentaires à élément semi-conducteur électroluminescent, dans laquelle le circuit intégré comprend :
- au moins un circuit électronique (120) destiné au pilotage de l'alimentation électrique des sources lumineuses élémentaires, et une zone de réception (112, 212) ayant un substrat, configurée pour recevoir ladite matrice,
- au moins une partie, y compris une partie de la zone de réception et du au moins un circuit électronique, qui se répète au moins une fois le long d'un axe principal (101),
- au moins une zone de connexion (213, 214) adjacente à la zone de réception (112, 212), la zone de connexion étant destinée à connecter le circuit électronique à au moins un composant externe,
la source lumineuse matricielle étant **caractérisée en ce que** la zone de connexion comprend au moins une ouverture traversante.

2. Source lumineuse selon la revendication 1, **caractérisée en ce que** le substrat de la zone de réception (112, 212) comprend au moins une partie du circuit électronique.

3. Source lumineuse selon la revendication 2, **caractérisée en ce que** les sources lumineuses élémentaires (131) sont électriquement connectées au circuit électronique (120) par des connexions verticales par rapport à l'étendue de la zone de réception (112).

4. Source lumineuse selon une des revendications 1 à 3, **caractérisée** en que la matrice (130) de sources lumineuses élémentaires se compose d'au moins deux composants matriciels (130', 130") distincts.

5. Source lumineuse selon l'un des revendications 1 à 4, **caractérisée en ce que** la zone de connexion s'étend le long d'au moins un bord du circuit intégré qui suit l'axe principal.

6. Source lumineuse selon l'une des revendications 1 à 5, **caractérisée en ce que** la zone de connexion comprend une pluralité de plots de connexion, dont les étendues respectives dépendent des signaux et/ou des intensités de courant électrique qu'elles sont configurées pour transmettre.

7. Source lumineuse selon une des revendications 1 à 6, **caractérisée en ce que** la zone de connexion comprend des moyens de connexion à une source d'électricité, les moyens de connexion étant formés par une couche de métal.

8. Module lumineux pour un véhicule automobile, le module comprenant un élément de dissipation thermique, un circuit imprimé et une source lumineuse matricielle, **caractérisé en ce que** la source lumineuse matricielle est conforme à une des revendication 1 à 7.

9. Module lumineux selon la revendication 8, **caractérisé en ce que** le substrat du circuit intégré est en contact thermique avec l'élément de dissipation thermique.

10. Module lumineux selon une des revendications 8 à 9, **caractérisé en ce que** la source lumineuse matricielle est électriquement reliée au circuit imprimé moyennant au moins une connexion par pontage.

## Patentansprüche

1. Matrixlichtquelle (100, 200) mit einer integrierten Schaltung (110, 210) und einer Matrix (130) von Elementarlichtquellen mit einem lichtemittierenden Halbleiterelement,
wobei die integrierte Schaltung umfasst:
- mindestens eine elektronische Schaltung (120) zur Steuerung der Stromversorgung der Elementarlichtquellen und einen Aufnahmebereich (112, 212) mit einem Substrat, der so konfiguriert ist, dass er die Matrix aufnimmt,
- mindestens einen Teil, einschließlich eines Teils des Aufnahmebereichs und der mindestens einen elektronischen Schaltung, der sich entlang einer Hauptachse (101) mindestens einmal wiederholt,
- mindestens einen Verbindungsbereich (213, 214), der an den Empfangsbereich (112, 212) angrenzt, wobei der Verbindungsbereich dazu dient, die elektronische Schaltung mit mindestens einer externen Komponente zu verbinden,
wobei die Matrixlichtquelle **dadurch gekennzeichnet ist, dass** der Verbindungsbereich mindestens eine Durchgangsöffnung umfasst.

2. Lichtquelle nach Anspruch 1, **dadurch gekennzeichnet, dass** das Substrat des Aufnahmebereichs (112, 212) mindestens einen Teil der elektronischen Schaltung umfasst.

3. Lichtquelle nach Anspruch 2, **dadurch gekennzeichnet, dass** die elementaren Lichtquellen (131) elektrisch mit der elektronischen Schaltung (120) durch Verbindungen verbunden sind, die in Bezug auf die Ausdehnung des Aufnahmebereichs (112) vertikal verlaufen.

4. Lichtquelle nach einem der Ansprüche 1 bis 3, **dadurch gekennzeichnet, dass** die Matrix (130) aus elementaren Lichtquellen aus mindestens zwei getrennten Matrixkomponenten (130', 130") besteht.

5. Lichtquelle nach einem der Ansprüche 1 bis 4, **dadurch gekennzeichnet, dass** sich der Verbindungsbereich entlang mindestens einer Kante des integrierten Schaltkreises erstreckt, die der Hauptachse folgt.

6. Lichtquelle nach einem der Ansprüche 1 bis 5, **dadurch gekennzeichnet, dass** der Verbindungsbereich eine Vielzahl von Verbindungspads umfasst, deren jeweilige Ausdehnungen von den Signalen und/oder elektrischen Stromstärken abhängen, die sie zu übertragen konfiguriert sind.

7. Lichtquelle nach einem der Ansprüche 1 bis 6, **dadurch gekennzeichnet, dass** der Verbindungsbereich Mittel zum Verbinden mit einer Stromquelle umfasst, wobei die Verbindungsmittel durch eine Metallschicht gebildet werden.

8. Lichtmodul für ein Kraftfahrzeug, wobei das Modul ein Wärmeableitungselement, eine Leiterplatte und eine Matrix-Lichtquelle umfasst, **dadurch gekennzeichnet, dass** die Matrix-Lichtquelle einem der Ansprüche 1 bis 7 entspricht.

9. Leuchtmodul nach Anspruch 8, **dadurch gekennzeichnet, dass** das Substrat der integrierten Schaltung in thermischem Kontakt mit dem wärmeableitenden Element steht.

10. Leuchtmodul nach einem der Ansprüche 8 bis 9, **dadurch gekennzeichnet, dass** die Matrixlichtquelle über mindestens eine Brückenverbindung mit der Leiterplatte elektrisch verbunden ist.

## Claims

1. An array light source (100, 200) comprising an integrated circuit (110, 210) and an array (130) of electroluminescent semiconductor element light sources,
in which the integrated circuit comprises :
- at least one electronic circuit (120) for driving the power supply to the elementary light sources, and a receiving area (112, 212) having a substrate, configured to receive said array,
- at least one part, including a part of the reception zone and of the at least one electronic circuit, which is repeated at least once along a main axis (101),
- at least one connection zone (213, 214) adjacent to the reception zone (112, 212), the connection zone being designed to connect the electronic circuit to at least one external component,
the matrix light source being **characterised in that** the connection zone comprises at least one through aperture.

2. A light source as claimed in claim 1, **characterised in that** the substrate of the receiving zone (112, 212) comprises at least part of the electronic circuit.

3. Light source according to claim 2, **characterized in that** the elementary light sources (131) are electrically connected to the electronic circuit (120) by connections vertical to the extent of the receiving area (112).

4. Light source according to one of claims 1 to 3, **characterized in that** the matrix (130) of elementary light sources is composed of at least two distinct matrix components (130', 130").

5. Light source according to one of claims 1 to 4, **characterised in that** the connection zone extends along at least one edge of the integrated circuit which follows the main axis.

6. A light source according to any one of claims 1 to 5, **characterised in that** the connection area comprises a plurality of connection pads, the respective extents of which depend on the signals and/or electric current intensities that they are configured to transmit.

7. A light source according to one of claims 1 to 6, **characterised in that** the connection area comprises means for connection to a source of electricity, the connection means being formed by a layer of metal.

8. A light module for a motor vehicle, the module comprising a heat sink, a printed circuit and a matrix light source, **characterised in that** the matrix light source is in accordance with one of claims 1 to 7.

9. The light module of claim 8, **characterised in that** the substrate of the integrated circuit is in thermal contact with the heat sink.

10. Light module according to one of claims 8 to 9, **characterised in that** the matrix light source is electrically connected to the printed circuit by means of at least one jumper connection.
